# EUROPEAN PATENT SPECIFICATION

(11) **EP 1 376 027 B1**
(45) Date of publication and mention of the grant of the patent: **24.01.2018**
(21) Application number: 02394076.0
(22) Date of filing: 26.06.2002
(51) Int. Cl.: F24J 2/48

(54) **Improvements to solar panels**
Verbesserungen zu Sonnenpaneelen
Améliorations de panneaux solaires

(43) Date of publication of application: 02.01.2004
(73) Proprietor: NuAire Limited, Caerphilly Mid Glamorgan CF83 1NA (GB)
(72) Inventor: Quigley, William Michael, Sandycove, County Dublin (IE)
(74) Representative: Davies, Gregory Mark

(56) References cited:
- EP-A- 0 384 787
- WO-A-96/25632
- WO-A-99/00338
- DE-A- 2 629 066
- DE-A- 19 806 533
- FR-A- 2 428 800
- US-A- 2 860 450
- US-A- 3 238 056
- US-A- 3 585 015
- US-A- 4 304 223
- US-A- 4 334 524
- US-A- 4 421 203

## Description

The present invention relates to improvements to solar. In particular, the invention is directed to improvements to solar panels such as the type as disclosed in Irish Patent Specification No. 64906. Such a solar panel comprises a housing, a cover on the housing which transmits incident solar radiation into the housing, a solar radiation absorber in the housing and air inlet and outlet ports to enable air to be circulated through the panel to collect heat. That absorber comprises a matrix of long strand glass fibres with the density of the matrix increasing from the cover to the base of the housing. The glass fibre matrix is bonded by a phenol formaldehyde resin.
European patent number 0384787 discloses a solar panel comprising a glazed box containing an absorber comprising a matrix of glass fibres. While glass fibres of this type may provide acceptable thermal absorption, it has been observed that this material may degrade over time leading to a loss of efficiency or failure of the solar collector panel.
The object of the invention is to provide a solar panel having improved performance and which is easier to manufacture.

The invention is defined in the appended claim 1 which is incorporated herein by reference.
The invention will hereinafter be more particularly described with reference to the accompanying drawings, which show by way of example only, an embodiment of a solar panel according to the invention.
In the drawings:
Figure 1 is a cross-sectional view through a solar panel or solar collector;
Figure 2 is an enlarged cross sectional view through the absorber of the solar panel of Figure 1;
Figure 3 is an elevation of an absorber manufacturing apparatus in accordance with the invention.

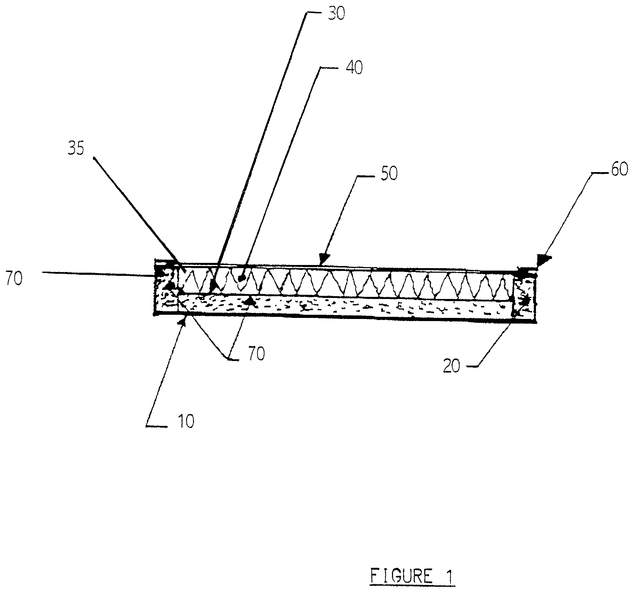

Referring to the drawings and initially to Figure 1, the solar panel comprises an outer metal box 10, a layer of mineral wool insulation 20, the outer surface of which is provided with a layer of aluminium reflector foil 30. Located within the cavity 35 defined by the foil 30 is an absorber 40. A 4mm thick low emittance coated toughened glass 50 is placed on top of the solar panel and held in place by an extrusion 60 and a silicon glazing seal 70.

The metal box 10 is formed by pressing a sheet of metal into the shape required. The insulation 20 must have a high thermal conductivity at a high temperature. Rockwool with a density of 100 kg/m³ is an example of a suitable insulation. The layer of foil 30 on the insulation 20 reflects any solar radiation, which penetrates through the absorber 40. The insulation 20 is sealed so that the air circulates through the panel with only flow in the cavity 35 created by insulation 20 and the glass 50 and not behind or around the insulation 20.

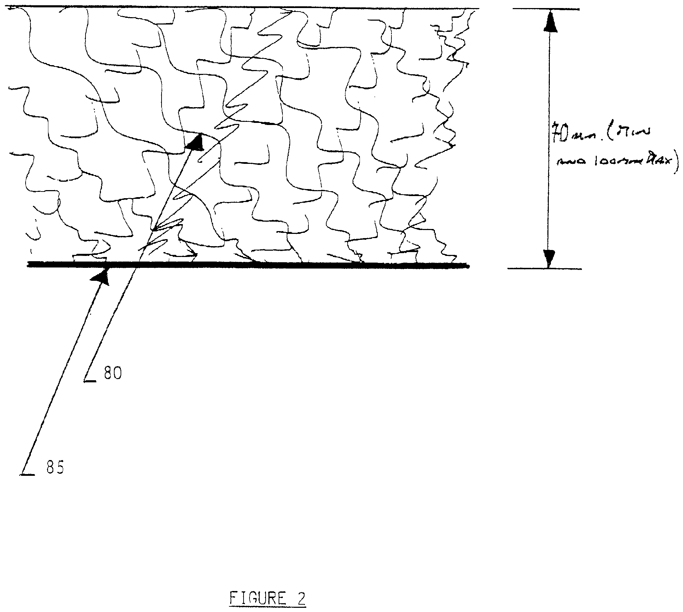

The absorber 40 will now be described in greater detail with reference to Figure 2 and comprises a matrix of fibres 80 which may be either glass fibres or steel wool fibres. Each of the fibres 80 is typically 3 to 4 metres in length, between 25 to 50 microns in diameter and does not contain chaff or dust which would be a health hazard, as well as an irritant to people occupying the house. The fibres 80 are bonded with melamine formaldehyde having black dye. The density of the absorber is typically between 3 to 4 kg/m³ and is generally even throughout the absorber. However at the base of the absorber 40 is a denser mat of fibres 85 which acts as a backing for the absorber. The mat 85 is about 2mm thick and functions as a light barrier and therefore causes any unabsorbed solar radiation to be absorbed at the bottom of the absorber 40. The mat 85 also prevents the foil 30 from being seen from outside.

The melamine formaldehyde, which acts as a binding agent for the absorber 40 keeps the absorber at between 70mm and 100mm thickness.

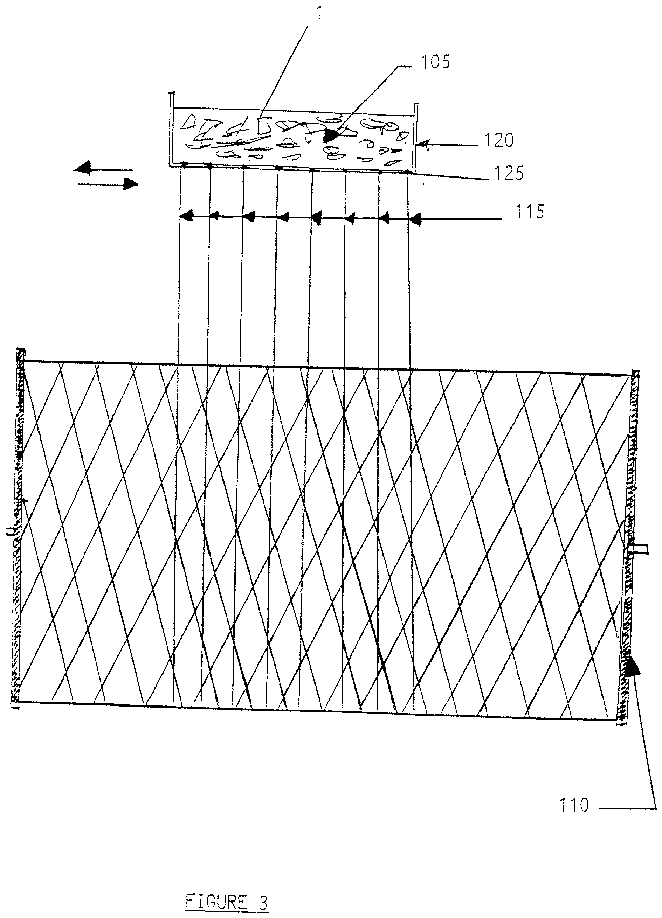

The black dye used in absorber 40 may be carbon black but preferably is of a material, which gives a selective absorbing nature to the coating on each of the fibres 85. Such a material allows short wave solar radiation to be absorbed by the absorber but is a poor emitter of heat thereby reducing the thermal losses from the absorber to the outside air. Examples of such material are iron oxide and chromium. The pressure drop across such an absorber is very low and requires a reduced fan power necessary to deliver approximately 10 to 15 litres of air per m² per second through the panel.
The low emittance glass 50 reduces heat lost from the top of the solar panel. Two further layers of glazing (not shown) may be used to make the panel a more efficient, high temperature collector. A layer of Teflon® plastic sheet is placed to contain the absorber. A layer of Tedlar® is then placed over this with an air space between the Teflon® and the Tedlar® and a further air space between the Tedlar® and the glass 50. This means that the collector is in effect triple glazed. Teflon® is used next to the absorber as it can withstand high temperatures. Tedlar® is used as it is diffused in appearance and will mask the 'crinkling' appearance of the Teflon® when it is at a high temperature. Apparatus 100 for manufacturing the absorber 40 is shown in Figure 3 and comprises a spinning drum 110 and a furnace box 120. A mixture of melamine formaldehyde and the black dye is mixed in advance and coated onto the drum 110. Glass 105 is placed in the furnace box 120 and melted by gas burners. The furnace box reciprocates across the surface of the spinning drum 110. Glass strands 115 emerge through orifices 125 and are laid down on the surface of the drum 110 to form an interlayer fibre. The interlayer is then drawn to form the matrix of the desired thickness and is cured to a temperature of approximately 250°C.
It is to be understood that the invention is not limited to the specific details described herein which are given by way of example only and that various modifications and alterations are possible without departing from the scope of the invention as defined in the appended claims.

## Claims

1. A solar panel comprising an outer metal box (10), a layer of insulation (20), the outer surface of which is provided with a layer of aluminium reflector foil (30) which defines a cavity, an absorber (40) located within the cavity (35) defined by the foil 30 with a low emittance glass (50) being placed on top of the solar panel, the absorber comprising a matrix of steel wool fibres, **characterized in that** beneath the low emittance glass (50) are two further layers of glazing namely a high layer of Teflon® plastic sheet placed over the absorber and a layer of Tedlar® is placed over the Teflon® sheet with an air space between the Teflon® and the Tedlar® sheets and a further air space between the Tedlar® sheet and the glass (50), thereby providing a triple glazed collector.

2. A solar panel according to Claim 1, in which the metal box (10) is formed by pressing a sheet of metal into the shape required, the insulation (20) having a high thermal conductivity at a high temperature such as rockwool, with the insulation (20) being sealed so that the air circulates through the panel with only flow in cavity (35) created between the insulation (20) and the glass (50) and not behind or around the insulation (20).

3. A solar panel according to Claim 1 or Claim 2, in which the matrix of fibres (80) with each of the fibres (80) being typically 3 to 4 metres in length, between 25 to 50 microns in diameter and not containing chaff or dust.

4. A solar panel according to Claim 3, in which the fibres (80) are bonded with melamine formaldehyde having black dye with the density of the absorber being typically between 3 to 4 kg/m³ and being generally even throughout the absorber.

5. A solar panel according to any one of the preceding claims, in which at the base of the absorber (40) is a denser mat of fibres (85) which acts as a backing for the absorber, and functions as a light barrier and therefore causes any unabsorbed solar radiation to be absorbed at the bottom of the absorber (40), the mat (85) also preventing the foil (30) from being seen from outside.

6. A solar panel according to claim 4, in which the black dye used in absorber (40) is carbon black or optionally is a material which gives a selective absorbing nature to the coating on each of the fibres (85) thereby allowing short wave solar radiation to be absorbed by the absorber but being a poor emitter of heat thereby reducing the thermal losses from the absorber to the outside air.

7. A solar panel according to Claim 6, in which the dye is iron oxide or chromium.

## Patentansprüche

1. Solarpaneel, umfassend einen äußeren Metallkasten (10), eine Isolationsschicht (20), deren Außenoberfläche mit einer Lage von Aluminium-Reflektorfolie (30) versehen ist, die einen Hohlraum definiert, einen Absorber (40), der in dem von der Folie (30) definierten Hohlraum (35) angeordnet ist, ein Glas (50) mit niedrigem Emissionsgrad, das obenliegend auf dem Solarpaneel angeordnet ist, wobei der Absorber eine Matrix aus Stahlwollfasern umfasst,
**dadurch gekennzeichnet, dass** unter dem Glas (50) mit niedrigem Emissionsgrad zwei weitere Verglasungsschichten angeordnet sind, nämlich eine obere Schicht aus Teflon®-Kunststoffplatte, die über dem Absorber angeordnet ist, und eine Schicht aus Tedlar®, die über der Teflon®-Platte angeordnet ist, mit einem Luftraum zwischen der Teflon®- und der Tedlar®-Platte und einem weiteren Luftraum zwischen der Tedlar®-Platte und dem Glas (50), um einen dreifach verglasten Kollektor zu ergeben.

2. Solarpaneel gemäß Anspruch 1, wobei der Metallkasten (10) durch Pressen einer Metallplatte in die benötigte Form gebildet ist, die Isolation (20) eine hohe Wärmeleitfähigkeit bei einer hohen Temperatur aufweist, wie z. B. Steinwolle, wobei die Isolation (20) abgedichtet ist, so dass die Luft nur mit Fluss in dem Hohlraum (35) zwischen der Isolation (20) und dem Glas (50) und nicht hinter oder um die Isolation (20) furch das Paneel zirkuliert.

3. Solarpaneel gemäß Anspruch 1 oder Anspruch 2, wobei in die Matrix von Fasern (80) jede der Fasern (80) typischerweise eine Länge von 3 bis 4 Meter und einen Durchmesser zwischen 25 und 50 Mikrometer aufweist und sie kein Häckselmaterial und keinen Staub enthält.

4. Solarpaneel gemäß Anspruch 3, wobei die Fasern (80) mit Melamin-Formaldehyd gebunden sind, das schwarzen Farbstoff mit einer Dichte in dem Absorber von typischerweise zwischen 3 und 4 kg/m³ und im Allgemeinen gleichmäßig in dem Absorber aufweist.

5. Solarpaneel gemäß einem der vorstehenden Ansprüche, wobei an der Basis des Absorbers (40) eine dichtere Matte von Fasern (85) vorhanden ist, die als Unterlage für den Absorber dient und als Lichtbarriere wirkt und daher bewirkt, dass jegliche nichtabsorbierte Sonnenstrahlung an dem Boden des Absorbers (40) absorbiert wird, wobei die Matte (85) auch verhindert, dass die Folie (30) von außen zu sehen ist.

6. Solarpaneel gemäß Anspruch 4, wobei der in dem Absorber (40) verwendete schwarze Farbstoff Ruß ist oder gegebenenfalls ein Material ist, das der Beschichtung jeder der Fasern (85) eine selektiv absorbierende Beschaffenheit verleiht und dadurch ermöglicht, dass kurzwellige Sonnenstrahlung von dem Absorber absorbiert wird, der aber ein schlechter Wärmeemitter ist, um so die Wärmeverluste aus dem Absorber an die Außenluft zu verringern.

7. Solarpaneel gemäß Anspruch 6, wobei der Farbstoff Eisenoxid oder Chrom ist.

## Revendications

1. Panneau solaire comprenant un coffre métallique extérieur (10), une couche d'isolant (20), dont la surface extérieure est pourvue d'une couche de feuille réfléchissante en aluminium (30) qui définit une cavité, un absorbeur (40) situé à l'intérieur de la cavité (35) définie par la feuille (30) avec une vitre (50) à faible émittance placée au-dessus du panneau solaire, l'absorbeur comprenant une matrice de fibres de laine d'acier, **caractérisé en ce que**, sous la vitre (50) à faible émittance se trouvent deux autres couches de vitrage, à savoir une couche haute de plaque de plastique Teflon® placée au-dessus de l'absorbeur et une couche de Tedlar® est placée au-dessus de la plaque de Teflon® avec un interstice entre les plaques de Teflon® et de Tedlar® et un autre interstice entre la plaque de Tedlar® et la vitre (50), constituant ainsi un insolateur à triple vitrage.

2. Panneau solaire selon la revendication 1, dans lequel le coffre métallique (10) est formé en pressant une plaque de métal de façon à lui donner la forme requise, l'isolant (20) présentant une conductivité thermique élevée à haute température, comme la laine de roche, l'isolant (20) étant installé de manière hermétique de telle sorte que l'air circule à travers le panneau en s'écoulant uniquement dans la cavité (35) créée entre l'isolant (20) et la vitre (50) et non derrière ou autour de l'isolant (20).

3. Panneau solaire selon la revendication 1 ou la revendication 2, dans lequel la matrice de fibres (80) comporte des fibres (80) qui font chacune typiquement 3 à 4 mètres de long, 25 à 50 micromètres de diamètre et ne contiennent ni fragments ni poussière.

4. Panneau solaire selon la revendication 3, dans lequel les fibres (80) sont liées au moyen de mélamine formaldéhyde comprenant un pigment noir, la densité de l'absorbeur étant typiquement comprise entre 3 et 4 kg/m³ et étant généralement uniforme dans l'ensemble de l'absorbeur.

5. Panneau solaire selon l'une quelconque des revendications précédentes, dans lequel, au niveau de la base de l'absorbeur (40), se trouve un tapis de fibres (85) plus dense qui sert de support pour l'absorbeur, et agit comme une barrière vis-à-vis de la lumière et a ainsi pour effet que tout rayonnement solaire non absorbé soit absorbé au fond de l'absorbeur (40), le tapis (85) empêchant également la feuille (30) d'être visible depuis l'extérieur.

6. Panneau solaire selon la revendication 4, dans lequel le pigment noir utilisé dans l'absorbeur (40) est le noir de carbone ou éventuellement est un matériau qui confère une nature d'absorption sélective au revêtement sur chacune des fibres (85), de sorte qu'il permet l'absorption d'un rayonnement solaire de courtes longueurs d'onde par l'absorbeur, mais constitue un mauvais émetteur de chaleur, de sorte qu'il réduit les pertes thermiques depuis l'absorbeur vers l'air extérieur.

7. Panneau solaire selon la revendication 6, dans lequel le pigment est l'oxyde de fer ou le chrome.
